# EUROPÄISCHE PATENTSCHRIFT

(11) **EP 3 653 577 B1**
(45) Veröffentlichungstag und Bekanntmachung des Hinweises auf die Patenterteilung: **06.10.2021**
(21) Anmeldenummer: 18206148.1
(22) Anmeldetag: 14.11.2018
(51) Int. Cl.: C01B 33/107, C23C 16/24

(54) **TRIS(TRICHLORSILYL)DICHLOROGALLYLGERMAN, VERFAHREN ZU DESSEN HERSTELLUNG UND DESSEN VERWENDUNG**
TRIS(TRICHLORSILYL)DICHLOROGALLYLGERMAN, METHOD FOR PRODUCING SAME AND ITS USE
TRIS-(TRICHLOROSILYL)-DICHLORO-GALLYL-GERMANE, SON PROCÉDÉ DE PRODUCTION ET SON UTILISATION

(43) Veröffentlichungstag der Anmeldung: 20.05.2020
(73) Patentinhaber: Evonik Operations GmbH, 45128 Essen (DE)
(72) Erfinder: WAGNER, Matthias, Prof. Dr., 61194 Niddatal (DE); TEICHMANN, Julian, 60327 Frankfurt am Main (DE); LERNER, Hans-Wolfram, Dr., 61440 Oberursel (DE)
(74) Vertreter: Evonik Patent Association

(56) Entgegenhaltungen:
- WO-A2-2004/036631
- US-A1- 2008 044 932
- MULLER L ET AL: "Trichlorosilylation of chlorogermanes and chlorostannanes with HSiCl3/Net3 followed by base-catalysed formation of (Me3Ge)2Si(SiCl3)2 and related branched stannylsilanes", JOURNAL OF ORGANOMETALLIC CHEMISTRY, ELSEVIER, AMSTERDAM, NL, Bd. 579, Nr. 1-2, 5. Mai 1999 (1999-05-05) , Seiten 156-163, XP004170561, ISSN: 0022-328X, DOI: 10.1016/S0022-328X(98)01218-2
- JULIAN TEICHMANN ET AL: "Tris(trichlorosilyl)tetrelide Anions and a Comparative Study of Their Donor Qualities", CHEMISTRY - A EUROPEAN JOURNAL, Bd. 25, Nr. 11, 21. Dezember 2018 (2018-12-21), Seiten 2740-2744, XP055580991, DE ISSN: 0947-6539, DOI: 10.1002/chem.201806298

## Beschreibung

Die vorliegende Erfindung betrifft die neue, chlorierte, ungeladene Sustanz Tris(trichlorsilyl)dichlorogallylgerman, ein Verfahren zur deren Herstellung sowie deren Verwendung.

Halogensilane, Polyhalogensilane, Halogengermane, Polyhalogengermane, Silan, Polysilane, German, Polygermane sowie entsprechende Mischverbindungen sind lange bekannt, vgl. neben den gängigen Lehrbüchern der anorganischen Chemie auch WO 2004/036631 A2 oder C.J. Ritter et al., J. Am. Chem. Soc., 2005, 127, 9855-9864.

Lars Müller et al. beschreiben im J. Organomet. Chem. 1999, 579, 156 - 163, eine Methode zur Herstellung von Si-Ge Bindungen durch Umsetzung von teilchlorierten organischen Germaniumverbindungen mit Trichlorsilan unter Zugabe von Triethylamin.

Eine weitere Möglichkeit, neutrale Si-Ge Verbindungen zu erzeugen, stellen Thomas Lobreyer et al. anhand der Umsetzung von SiH₄ und GeH₄ mit Natrium vor (Angew. Chem. 1993, 105, 587 - 588).

Die Patentanmeldungen EP 17173940.2, EP 17173951.9 und EP 17173959.2 offenbaren weitere Si-Ge Verbindungen und Verfahren zu deren Herstellung.

In der WO 2004/036631 A2 werden verschiedene halogenierte Silicium-Germanium-Verbindungen beschrieben, die zum Abscheiden von Si-Ge-Schichten eingesetzt werden können. Ga-dotierte Schichten werden hier nicht offenbart.

Im Aufsatz von Müller et al., "Trichlorosilylation of chlorogermanes and chlorostannanes with HSiCl3/NEt3 followed by base-catalysed formation of (Me3Ge)2Si(SiCl3)2 and related branched stannylsilanes", Journal of Organometallic Chemistry, Elsevier, Amsterdam, NL, Bd. 579, Nr. 1-2, 1999, Seiten 156 -163, werden halogenierte Si-Ge-Verbindungen wie beispielsweise Me₃GeSiCl₃ vorgeschlagen. Auch hier finden mit Gallium dotierte Systeme keine Erwähnung.

US 2008/044932 A1 offenbart die Herstellung von Si-Ge-Schichten aus gasförmigem Monosilan und Monogerman. Als Dotierstoffe werden Trimethylgallium und Galliumchlorid vorgeschlagen.

So ist man seitens der Grundlagenforschung bestrebt, neue Verbindungen aufzufinden und neue Herstellungswege zu suchen, insbesondere auch mit Hinblick auf mögliche industrielle sowie ggf. verbesserbare Anwendungen.

Der vorliegenden Erfindung lag die Aufgabe zugrunde, eine neue Synthesemöglichkeit zur Herstellung einer ungeladenen Silicium-Germanium Verbindung ohne den Einsatz pyrophorer oder giftiger Substanzen bereit zu stellen.

Eine völlig neue Synthesemöglichkeit wurde mit der Umsetzung von Ammonium- bzw. Phosphoniumtris(trichlorosilyl)germanid-Salzen des Typs [R₄N][Ge(SiCl₃)₃] bzw. [R₄P][Ge(SiCl₃)₃] mit GaCl₃ und alkylischen oder aromatischen Resten R gefunden, die zu einer ungeladenen, chlorierten und mit Gallium dotierten Si-Ge Verbindung führt. Das Überraschende an dieser neuen Synthese ist unter Anderem, dass Gallium in eine bestehende Si-Ge Verbindung in lediglich einem Schritt eingeführt wird und das resultierende Tris(trichlorsilyl)dichlorogallylgerman *ungeladen* ist.

Gegenstand der Erfindung ist demnach die Substanz Tris(trichlorsilyl)dichlorogallylgerman der Formel (I): 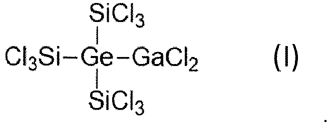 Gleichfalls Gegenstand ist das Verfahren zur Herstellung des erfindungsgemäßen Tris(trichlorsilyl)dichlorogallylgerman, indem man
(a) zumindest ein Tris(trichlorosilyl)germanidsalz des Typs [X][Ge(SiCl₃)₃] mit
   X = Ammonium (R₄N) und/oder Phosphonium (R₄P),
   R = alkylischer oder aromatischer Rest,
   mit GaCl₃ mischt, und
(b) in Umgebung zumindest eines Chlorkohlenwasserstoffes bei einer Temperatur von 5 bis 40 °C umsetzt, wobei man ein Rohprodukt erhält, das Salze [R₄N][GaCl₄] und/oder [R₄P][GaCl₄], und Tris(trichlorsilyl)dichlorogallylgerman enthält,
   und anschließend dieses Rohprodukt
(c) in zumindest ein unpolares Lösungsmittel einbringt und den unlöslichen Rückstand abtrennt, und anschließend
(d) das unpolare Lösungsmittel entfernt, wobei Tris(trichlorsilyl)dichlorogallylgerman erhalten wird.

Das Verfahren hat den Vorteil, dass weder pyrophore, noch giftige Substanzen wie z.B. SiH₄, GeH₄ oder Natrium eingesetzt werden müssen. Zwar sind im Stand der Technik bereits Verfahren bekannt, die den Einsatz solch gefährlicher Substanzen umgehen. Doch diese konventionellen Verfahren bringen in der Regel neutrale Si-Ge-Verbindungen mit organischen Resten hervor. Organische Reste verhindern den Einsatz der Si-Ge-Verbindungen in solchen Abscheidungsreaktionen, die für die Halbleiterelektronik interessant sind, weil bei den während der Abscheidung eingestellten Temperaturen SiC gebildet wird. SiC ist nichtleitend und zerstört die gewünschte leitende oder halbleitende Eigenschaft von Si-Ge-Schichten.

Ebenso wenig können salzartige Si-Ge-Verbindungen in der Halbleiterelektronik eingesetzt werden, da in solchen Substanzen organische Reste vorhanden sind. In dem erfindungsgemäßen Verfahren wird dagegen weder eine salzartige Si-Ge-Verbindung erzeugt, noch sind organische Reste anwesend. Vielmehr wird in dem beanspruchten Verfahren in einem einzigen Schritt eine bereits bestehende Si-Ge-Verbindung mit Gallium dotiert, und zugleich ein salzartiger Ausgangsstoff in ein ungeladenes, nicht-ionisches Produkt überführt. Also stellt sich als weiterer, immens wichtiger Vorteil heraus, dass das erfindungsgemäße bzw. das erfindungsgemäß erhaltene Tris(trichlorsilyl)dichlorogallylgerman problemlos in der Halbleiterelektronik eingesetzt werden kann.

Somit ist ebenfalls Gegenstand der Erfindung die Verwendung des erfindungsgemäßen Tris(trichlorsilyl)dichlorogallylgerman als Prekursor für die Abscheidung von mit Gallium dotierten Si-Ge-Schichten.

Die Erfindung wird im Folgenden näher erläutert.

Im Schritt a des erfindungsgemäßen Verfahrens können vorzugsweise 2 Äquivalente GaCl₃ pro Äquivalent Tris(trichlorosilyl)germanidsalz des Typs [X][Ge(SiCl₃)₃] eingesetzt werden, mit X = Ammonium (R₄N) und/oder Phosphonium (R₄P).

Bei der Umsetzung, die in dem Schritt b des erfindungsgemäßen Verfahrens stattfindet, lagert sich eine GaCl₂-Gruppe an das zentrale Germaniumatom an, und es entsteht in dem Rohprodukt die chlorierte ungeladene Verbindung Ge(SiCl₃)₃GaCl₂.

Die Ammonium- bzw. Phosphoniumchlorid-Salze bilden mit GaCl₃ Salze des Typs [R₄N][GaCl₄] bzw. [R₄P][GaCl₄], die ebenfalls im Rohprodukt enthalten sind. Von diesen salzartigen Verbindungen wird das ungeladene Molekül der Formel (I) durch Extraktion mit unpolaren Lösungsmitteln abgetrennt und in Reinform gewonnen. Als unpolare Lösungsmittel sind vorteilhafterweise Pentan, Hexan und/oder Benzol geeignet. Besonders bevorzugt kann n-Hexan eingesetzt werden.

Die Umsetzung im Schritt b des erfindungsgemäßen Verfahrens kann vorteilhaft bei Raumtemperatur durchgeführt werden. Zusätzlich oder alternativ zu dieser Option kann im Schritt d das unpolare Lösungsmittel bei Raumtemperatur entfernt werden.

Des Weiteren kann es vorteilhaft sein, im Schritt b des erfindungsgemäßen Verfahrens als Chlorkohlenwasserstoff Dichlormethan CH₂Cl₂ einzusetzen.

Eine weitere Option besteht darin, im Schritt b des erfindungsgemäßen Verfahrens R = Et zu wählen.

Vorzugsweise kann im Schritt c des erfindungsgemäßen Verfahrens das unpolare Lösungsmittel aus Hexan, n-Hexan, Pentan, und/oder Benzol ausgewählt sein. Besonders bevorzugt kann im Schritt c n-Hexan eingesetzt werden.

Eine weiterhin bevorzugte Ausführungsform des erfindungsgemäßen Verfahrens besteht darin, dass man im Schritt a [X][Ge(SiCl₃)₃] und GaCl₃ mittels Rühren mischt, wobei diese Komponenten vorzugsweise in festem Zustand sind, vorzugsweise in Sauerstoff freier Umgebung mischt, besonders bevorzugt unter Schutzgas, Stickstoff oder Argon, und im Schritt b das im Schritt a erhaltene Gemisch vollständig in dem oder den Chlorkohlenwasserstoffen löst, und nach einer Zeit von 0,1 bis 24 Stunden, vorzugsweise nach 1 bis 5 Stunden den oder die Chlorkohlenwasserstoffe entfernt, vorzugsweise bei einer Temperatur von 5 bis 40 °C, besonders bevorzugt bei Raumtemperatur, weiterhin bevorzugt in Sauerstoff freier trockener Umgebung, besonders bevorzugt in einer isolierten Umgebung, weiterhin bevorzugt unter Normaldruck oder vermindertem Druck, besonders bevorzugt im Bereich von 1 bis 500 hPa.

Es kann des Weiteren vorteilhaft sein, in dem Schritt c des erfindungsgemäßen Verfahrens nach dem Einbringen des Rohproduktes die Temperatur des oder der unpolaren Lösungsmittel von 1 mal bis 5 mal, vorzugsweise 3 mal von RT auf erhöhte Temperatur zu bringen, vorzugsweise auf den Siedepunkt zumindest eines unpolaren Lösungsmittels, und anschließend abkühlen lässt, vorzugsweise auf RT.

Das nachfolgende Beispiel erläutert die vorliegende Erfindung zusätzlich, ohne den Gegenstand zu beschränken. Der Begriff "Raumtemperatur" wird mit "RT" abgekürzt.

Im Beispiel 1 ist die Umsetzung von [Et₄N][Ge(SiCl₃)₃] mit GaCl₃ beschrieben. Die Umsetzung anderer Ammonium- bzw. Phosphonium(trichlorosilyl)germanid-Salze des Typs [R₄N][Ge(SiCl₃)₃] bzw. [R₄P][Ge(SiCl₃)₃] lässt sich analog durchführen.

### Analytische Methoden der Kristallstrukturbestimmung

Die Daten für alle Strukturen wurden bei 173 K mit einem STOE IPDS II Zweikreisdiffraktometer mit einer Genix Mikrofokusröhre mit Spiegeloptik unter Verwendung von Mo*K*_{α} Strahlung (*λ* = 0,71073 Å) gesammelt und mit dem frame scaling procedure des Programms *X-AREA* (Stoe & Cie, 2002) skaliert. Die Strukturen wurden mit direkten Methoden mit Hilfe des Programms *SHELXS* (Sheldrick, 2008) gelöst und gegen *F²* mit der full-matrix least-squares Technik verfeinert. Zellparameter wurden durch Verfeinerung gegen θ Werte der Reflexe mit *I*>6σ(*I*) bestimmt.

### Beispiel 1: Herstellung von Tris(trichlorsilyl)dichlorogallylgerman (1).

Die Synthese erfolgte gemäß **Gleichung 1** aus [Et₄N][Ge(SiCl₃)₃] mit GaCl₃ unter Zugabe von CH₂Cl₂.

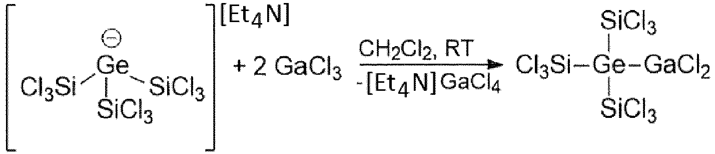

**Gleichung 1:** Umsetzung von [Et₄N][Ge(SiCl₃)₃] und GaCl₃ bei RT unter Zugabe von CH₂Cl₂.

Die Umsetzung wurde in einer Glovebox durchgeführt.

[Et₄N][Ge(SiCl₃)₃] in einer Menge von 0,050 g, entsprechend 0,082 mmol, und GaCl₃ in einer Menge von 0,028 g, entsprechend 0,16 mmol, wurden in festem Zustand vermischt und anschließend vollständig in Dichlormethan CH₂Cl₂ gelöst.

Nach 3 Stunden wurde das Dichlormethan bei RT langsam verdampft. Nach einem Tag hatte sich ein Gemisch aus Ge(SiCl₃)₃GaCl₂ *(**1**)* und [Et₄N][GaCl₄] als kristallines Rohprodukt gebildet. Das Rohprodukt wurde dreimal mit je 7 ml *n*-Hexan bis zum Sieden erhitzt. Anschließend wurde die klare, farblose *n*-Hexan-Lösung mit einer Spritze vom unlöslichen Rückstand abgetrennt.

Das unpolare Lösungsmittel wurde anschließend langsam bei RT entfernt, und nach einem Tag konnte Ge(SiCl₃)₃GaCl₂ (***1***) als kristalliner Stoff isoliert werden.

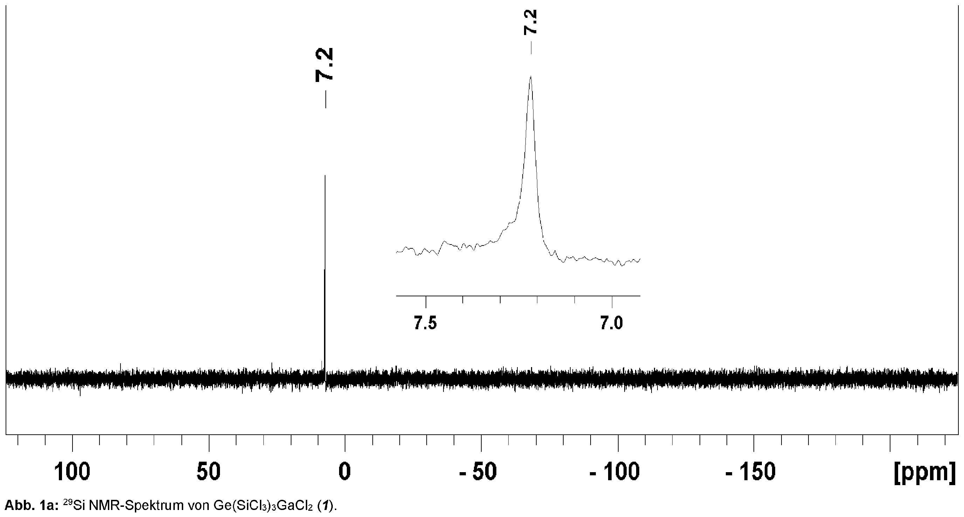

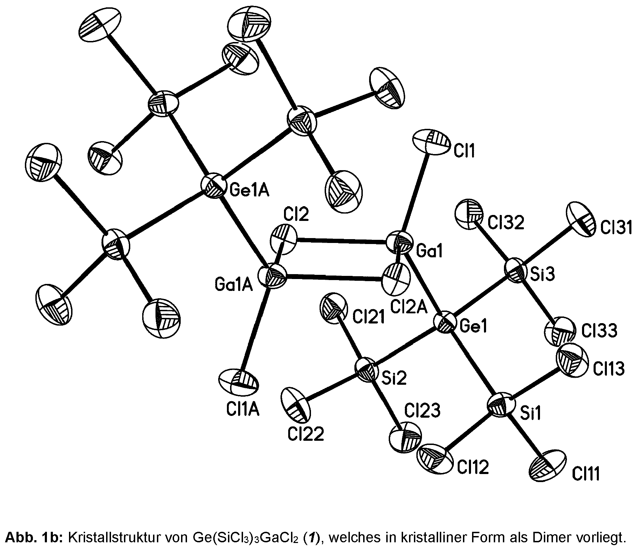

Das ²⁹Si NMR Spektrum des erfindungsgemäßen Produktes ***1*** ist in **Abb. 1a**, und das Ergebnis seiner röntgendiffraktometrischen Analyse in **Abb. 1b** dargestellt.

Die Daten der ²⁹Si NMR-spektroskopischen Untersuchung: **²⁹Si NMR (99,4 MHz, CD₂Cl₂, 298 K):** δ = 7,2 ppm.

## Patentansprüche

1. Tris(trichlorsilyl)dichlorogallylgerman der Formel (I):

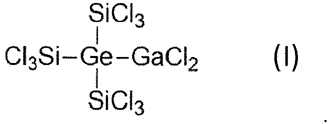

2. Verfahren zur Herstellung des Tris(trichlorsilyl)dichlorogallylgerman nach Anspruch 1, indem man
(a) zumindest ein Tris(trichlorosilyl)germanidsalz des Typs [X][Ge(SiCl₃)₃] mit X = Ammonium (R₄N) und/oder Phosphonium (R₄P),
R = alkylischer oder aromatischer Rest,
mit GaCl₃ mischt, und
(b) in Umgebung zumindest eines Chlorkohlenwasserstoffes bei einer Temperatur von 5 bis 40 °C umsetzt, wobei man ein Rohprodukt erhält, das Salze
[R₄N][GaCl₄] und/oder [R₄P][GaCl₄], und Tris(trichlorsilyl)dichlorogallylgerman enthält,
und anschließend dieses Rohprodukt
(c) in zumindest ein unpolares Lösungsmittel einbringt und den unlöslichen Rückstand abtrennt, und anschließend
(d) das unpolare Lösungsmittel entfernt, wobei
Tris(trichlorsilyl)dichlorogallylgerman erhalten wird.

3. Verfahren nach Anspruch 2, wobei im Schritt b die Umsetzung bei Raumtemperatur durchgeführt wird, und/oder im Schritt d das unpolare Lösungsmittel bei Raumtemperatur entfernt wird.

4. Verfahren nach einem der vorhergehenden Ansprüche, wobei im Schritt b als Chlorkohlenwasserstoff Dichlormethan CH₂Cl₂ eingesetzt wird.

5. Verfahren nach einem der vorhergehenden Ansprüche, wobei im Schritt b R = Et gewählt wird.

6. Verfahren nach einem der vorhergehenden Ansprüche, **dadurch gekennzeichnet, dass** man im Schritt c das unpolare Lösungsmittel aus Hexan, n-Hexan, Pentan, und/oder Benzol auswählt, vorzugsweise n-Hexan einsetzt.

7. Verfahren nach einem der vorhergehenden Ansprüche, **dadurch gekennzeichnet, dass** man im Schritt a
[X][Ge(SiCl₃)₃] und GaCl₃, wobei diese Komponenten vorzugsweise in festem Zustand sind, mittels Rühren mischt, vorzugsweise
in Sauerstoff freier Umgebung mischt, besonders bevorzugt unter Schutzgas, Stickstoff oder Argon,
und im Schritt b
das im Schritt a erhaltene Gemisch vollständig in dem oder den Chlorkohlenwasserstoffen löst, und
nach einer Zeit von 0,1 bis 24 Stunden, vorzugsweise nach 1 bis 5 Stunden den oder die Chlorkohlenwasserstoffe entfernt, vorzugsweise bei einer Temperatur von 5 bis 40 °C, besonders bevorzugt bei Raumtemperatur, weiterhin bevorzugt in Sauerstoff freier trockener Umgebung, besonders bevorzugt in einer isolierten Umgebung, weiterhin bevorzugt unter Normaldruck oder vermindertem Druck, besonders bevorzugt im Bereich von 1 bis 500 hPa.

8. Verfahren nach einem der vorhergehenden Ansprüche, **dadurch gekennzeichnet, dass** man im Schritt c nach dem Einbringen des Rohproduktes die Temperatur des oder der unpolaren Lösungsmittel von 1 mal bis 5 mal, vorzugsweise 3 mal von RT auf erhöhte Temperatur bringt, vorzugsweise auf den Siedepunkt zumindest eines unpolaren Lösungsmittels, und anschließend abkühlen lässt, vorzugsweise auf RT.

9. Verwendung des
Tris(trichlorsilyl)dichlorogallylgerman nach Anspruch 1
als Prekursor für die Abscheidung von mit Gallium dotierten Si-Ge-Schichten.

## Claims

1. Tris(trichlorosilyl)dichlorogallylgermane of the formula (I):

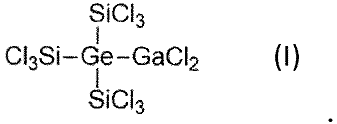

2. Process for preparing the tris(trichlorosilyl)dichlorogallylgermane according to Claim 1, by
(a) mixing at least one tris(trichlorosilyl)germanide salt of the [X] [Ge (SiCl₃)₃] type where X = ammonium (R₄N) and/or phosphonium (R₄P),
R = alkylic or aromatic radical,
with GaCl₃, and
(b) reacting same in an environment consisting of at least one chlorinated hydrocarbon at a temperature of 5 to 40°C to obtain a crude product comprising salts [R₄N] [GaCl₄] and/or [R₄P][GaCl₄] and tris(trichlorosilyl)dichlorogallylgermane,
and subsequently
(c) introducing said crude product into at least one nonpolar solvent and separating off the insoluble residue, and subsequently
(d) removing the nonpolar solvent,
to obtain tris(trichlorosilyl)dichlorogallylgermane.

3. Process according to Claim 2, wherein, in step b, the reaction is conducted at room temperature, and/or, in step d, the nonpolar solvent is removed at room temperature.

4. Process according to any of the preceding claims, wherein, in step b, the chlorinated hydrocarbon used is dichloromethane CH₂Cl₂.

5. Process according to any of the preceding claims, wherein, in step b, R = Et is chosen.

6. Process according to any of the preceding claims, **characterized in that**, in step c, the nonpolar solvent is selected from hexane, n-hexane, pentane and/or benzene; n-hexane is preferably used.

7. Process according to any of the preceding claims, **characterized in that**, in step a,
[X] [Ge(SiCl₃)₃] and GaCl₃, these components preferably being in the solid state, are mixed by means of stirring, preferably
mixed in an oxygen-free environment, particularly preferably under protective gas, nitrogen or argon, and, in step b,
the mixture obtained in step a is completely dissolved in the chlorinated hydrocarbon(s), and,
after a time of 0.1 to 24 hours, preferably after 1 to 5 hours,
the chlorinated hydrocarbon(s) are removed, preferably at a temperature of 5 to 40°C, particularly preferably at room temperature, additionally preferably in an oxygen-free, dry environment, particularly preferably in an isolated environment, additionally preferably under standard pressure or reduced pressure, particularly preferably in the range from 1 to 500 hPa.

8. Process according to any of the preceding claims, **characterized in that**,
in step c, after the introduction of the crude product, the temperature of the nonpolar solvent(s) is brought for from 1 to 5 times, preferably 3 times, from RT to elevated temperature, preferably to the boiling point at least of one nonpolar solvent, and subsequently allowed to cool, preferably to RT.

9. Use of the tris(trichlorosilyl)dichlorogallylgermane according to Claim 1
as precursor for the deposition of gallium-doped Si-Ge layers.

## Revendications

1. Tris(trichlorosilyl)dichlorogallylgermane de formule (I) :

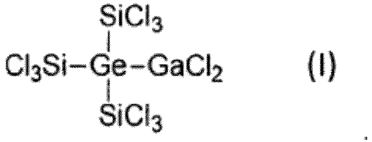

2. Procédé pour la préparation du tris(trichlorosilyl)dichlorogallylgermane selon la revendication 1, dans lequel
(a) on mélange au moins un sel de tris(trichlorosilyl)germanure du type [X][Ge(SiCl₃)₃] avec X = ammonium (R₄N) et/ou phosphonium (R₄P),
R = radical alkylique ou aromatique,
avec GaCl₃, et
(b) on transforme en présence d'au moins un chlorohydrocarbure à une température de 5 à 40 °C, dans lequel on obtient un produit brut, qui contient des sels [R₄N] [GaCl₄] et/ou [R₄P][GaCl₄], et du tris(trichlorosilyl)dichlorogallylgermane, et ensuite
(c) on introduit ce produit brut dans au moins un solvant apolaire et on sépare le résidu insoluble, et ensuite
(d) on élimine le solvant apolaire,
le tris(trichlorosilyl)dichlorogallylgermane étant obtenu.

3. Procédé selon la revendication 2, dans lequel, dans l'étape b, la transformation est mise en œuvre à température ambiante, et/ou dans l'étape d, le solvant apolaire est éliminé à température ambiante.

4. Procédé selon l'une quelconque des revendications précédentes, dans lequel, dans l'étape b, du dichlorométhane CH₂Cl₂ est utilisé en tant que chlorohydrocarbure.

5. Procédé selon l'une quelconque des revendications précédentes, dans lequel, dans l'étape b, R = Et est choisi.

6. Procédé selon l'une quelconque des revendications précédentes, **caractérisé en ce qu'**on choisit, dans l'étape c, le solvant apolaire parmi l'hexane, le n-hexane, le pentane et/ou le benzène, de préférence on utilise le n-hexane.

7. Procédé selon l'une quelconque des revendications précédentes, **caractérisé en ce que**, dans l'étape a,
on mélange [X][Ge(SiCl₃)₃] et GaCl₃ au moyen d'une agitation, ces composants étant de préférence à l'état solide, de préférence
on mélange dans un environnement exempt d'oxygène, particulièrement préférablement sous gaz protecteur, azote ou argon,
et dans l'étape b
on dissout totalement le mélange obtenu dans l'étape a dans le ou les chlorohydrocarbures, et
après une durée de 0,1 à 24 heures, de préférence après 1 à 5 heures, on élimine les chlorohydrocarbures, de préférence à une température de 5 à 40 °C, particulièrement préférablement à température ambiante, encore préférablement dans un environnement sec exempt d'oxygène, particulièrement préférablement dans un environnement isolé, encore préférablement sous pression normale ou pression réduite, particulièrement préférablement dans la plage de 1 à 500 hPa.

8. Procédé selon l'une quelconque des revendications précédentes, caractérisé ce que, dans l'étape c après l'introduction du produit brut, on amène la température du ou des solvants apolaires 1 fois à 5 fois, de préférence 3 fois de la température ambiante à une température élevée, de préférence au point d'ébullition d'au moins un solvant apolaire, et ensuite on laisse refroidir, de préférence à température ambiante.

9. Utilisation du tris(trichlorosilyl)dichlorogallylgermane selon la revendication 1 en tant que précurseur pour le dépôt de couches de Si-Ge dopées au gallium.
